# FASCICULE DE BREVET EUROPEEN

(11) **EP 1 828 786 B1**
(45) Date de publication et mention de la délivrance du brevet: **08.07.2009**
(21) Numéro de dépôt: 05848345.4
(22) Date de dépôt: 13.12.2005
(51) Int. Cl.: G01R 1/20

(54) **DISPOSITIF DE MESURE D'UN COURANT CIRCULANT DANS UN CABLE**
VORRICHTUNG ZUR MESSUNG EINES STROMFLUSSES IN EINEM KABEL
DEVICE FOR MEASURING A CURRENT FLOWING IN A CABLE

(30) Priorité: 20.12.2004 FR 0413593
(43) Date de publication de la demande: 05.09.2007
(73) Titulaire: Johnson Controls Technology Company, Holland, MI 49423 (US); Kromberg & Schubert Gmbh Co. KG, 42389 Wuppertal (DE)
(72) Inventeur: CONDAMIN, Bruno, F-95300 Pontoise (FR); MUIS, Pascal, F-95300 Pontoise (FR); BAGES, Ghislain, F-78330 Fontenay Le Fleury (FR)
(74) Mandataire: Fruchard, Guy
(86) Numéro de dépôt international: PCT/FR2005/003113
(87) Numéro de publication internationale: WO 2006/067300

(56) Documents cités:
- EP-A- 1 107 009
- DE-A- 10 000 500
- US-A- 5 214 407
- US-B1- 6 218 805
- US-B1- 6 304 062

## Description

La présente invention concerne un dispositif de mesure d'un courant circulant dans un câble, et plus particulièrement un câble d'alimentation relié à une batterie.

### ARRIERE PLAN DE L'INVENTION

Afin d'assurer un contrôle de la charge d'une batterie, on connaît des dispositifs de mesure comportant un shunt en forme de plaque monté en série avec le câble d'alimentation des différents équipements reliés à la batterie, le shunt de mesure étant associé à une carte électronique de mesure relié à un câble de transmission de données de mesure.

On connaît différents modes de réalisation du dispositif de mesure précité. On connaît en particulier du document EP 1 238 288 un dispositif de mesure intégré à une cosse de batterie dans lequel le shunt de mesure comporte une portion de mesure en alliage résistif associé à une carte électronique de mesure, et relié à des portions de raccordement conductrice le long de deux bords opposés de la portion de mesure, les portions de raccordement étant toutes les deux supportées par la cosse de batterie. La réalisation de ce dispositif de mesure est complexe et son coût est donc élevé au regard des coûts généralement admis pour ce type d'équipement.

On connaît également du document US-A-6 304 062 - BATSON, un dispositif de mesure de courant comportant un shunt monté entre les bornes de deux éléments de batterie adjacents. Les éléments de batterie doivent donc avoir une structure spécialement adaptée pour recevoir le dispositif de mesure de courant BATSON, ce qui est incompatible avec un libre changement de la batterie.

### OBJET DE L'INVENTION

Un but de l'invention est de proposer un dispositif de mesure du type précité ayant une structure simple permettant une réalisation industrielle à faible coût.

### RESUME DE L'INVENTION

En vue de la réalisation de ce but, on propose selon l'invention un dispositif de mesure comportant un shunt de mesure en forme de plaque monté en série avec un câble et associé à une carte électronique de mesure reliée à un câble de transmission de données, le shunt de mesure comportant une portion de mesure en alliage résistif reliée à des portions de raccordements réalisée en alliage résistif en une seule pièce avec la portion de mesure, et le câble d'alimentation a une extrémité fixée par une soudure autogène sur une face d'une partie de raccordement du shunt de mesure, la portion de raccordement opposée à l'extrémité du câble étant directement fixée par une soudure à une cosse de batterie, au niveau d'une patte conductrice réalisée en une seule pièce avec la cosse de batterie.

Ainsi le shunt de mesure peut être réalisé par simple découpage d'une plaque d'alliage résistif et la fixation de l'extrémité de câble peut aisément être automatisée.

Par ailleurs, il est ainsi possible d'automatiser également la fixation du shunt à la cosse de batterie et la fixation obtenue est d'une grande résistance ce qui permet de disposer le dispositif de mesure en porte à faux par rapport à la cosse de batterie sans détérioration du dispositif.

### BREVE DESCRIPTION DES FIGURES

D'autres caractéristiques et avantages de l'invention apparaîtront à la lecture de la description qui suit de trois modes de réalisation particuliers non limitatifs de l'invention en référence aux figures ci-jointes parmi lesquelles :
- la figure 1 est une vue en perspective éclatée d'un dispositif de mesure selon un premier mode de réalisation de l'invention,
- la figure 2 est une vue en coupe selon la ligne II-II de la figure 1 du premier mode de réalisation de l'invention une fois terminé,
- la figure 3 est une vue en perspective d'un second mode de réalisation du shunt de mesure et de ses connexions,
- les figures 4 à 6 illustrent les différentes étapes de réalisation d'un troisième mode de réalisation du shunt et de ses connexions,
- la figure 7 est une vue en coupe selon la ligne VII-VII de la figure 6 du troisième mode de réalisation de l'invention une fois terminé.

### DESCRIPTION DETAILLEE DE L'INVENTION.

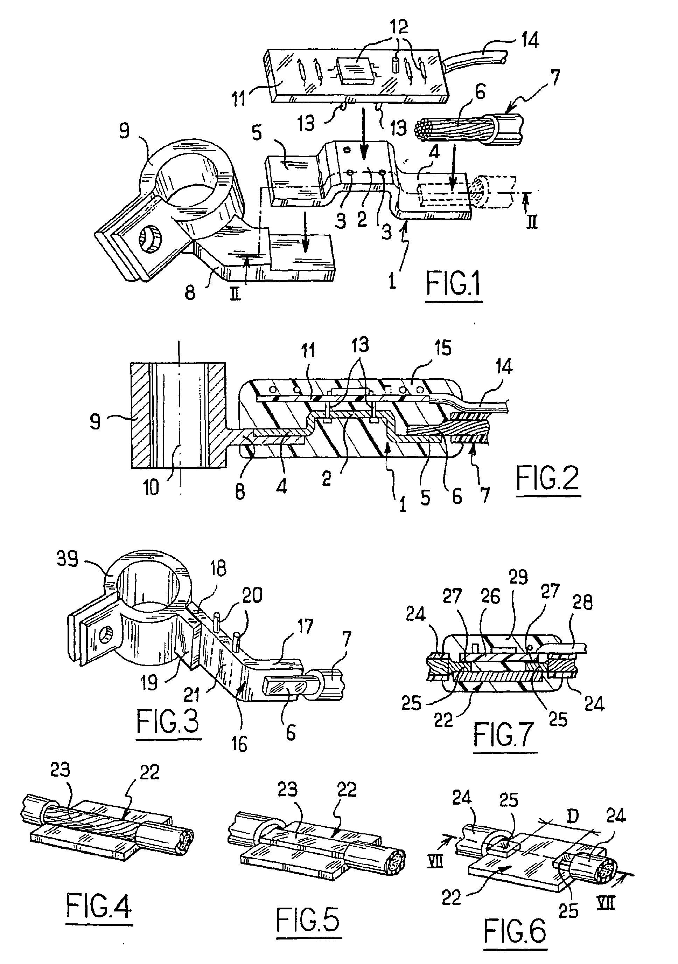

En référence aux figures 1 et 2, dans le premier mode de réalisation de l'invention le dispositif de mesure comporte un shunt de mesure généralement désigné en 1, réalisé en une seule pièce en alliage résistif tel que du manganin et comportant une portion centrale délimitée par des perçages 3 pour former une portion de mesure 2 du shunt 1. De part et d'autre de la portion de mesure 2, le shunt de mesure 1 comporte des portions de raccordement 4,5 qui dans ce mode de réalisation s'étendent parallèlement à la portion de mesure 2 en étant décalées de celle-ci.

La portion de raccordement 4 est fixée à l'extrémité 6 de l'âme conductrice d'un câble 7 servant à l'alimentation d'équipements non représentés. Selon un mode de réalisation préféré illustré par la figure, l'extrémité 6 qui se présente initialement sous forme d'un faisceau de fils conducteurs est appliquée sur une face de la patte de raccordement 4 et chauffée, par exemple par des ultrasons pour provoquer la fusion des fils conducteurs et réaliser une soudure autogène comme illustrée en pointillé sur la figure 1.

La portion de raccordement 5 opposée au câble 7 est fixée de la même façon, c'est à dire par une soudure autogène, sur une face d'une patte support 8 en matériau conducteur tel que du laiton, elle même réalisée en une seule pièce avec une cosse de batterie 9. Dans le mode de réalisation des figures 1 et 2, la patte support 8 s'étend perpendiculairement à l'axe 10 de la cosse de batterie 9 au voisinage de la base de la cosse.

Par ailleurs le dispositif de mesure comporte de façon connue en soi une carte électronique 11 portant des composants 12 formant un circuit de mesure et pourvue à cet effet de tiges de liaison 13 insérées lors du montage dans les perçages 3 et soudées dans ceux-ci pour mesurer une différence de potentiel aux extrémités de la portion de mesure 2 du shunt 1. La carte électronique 11 est également reliée de façon connue en soi à un câble 14 de transmission de données.

Comme illustré par la figure 2 un bloc de résine 15 est moulé autour du dispositif de mesure après assemblage des différents composants afin de compléter la liaison mécanique entre le câble 7 et la patte support 8 de la cosse 9 de sorte que le dispositif de mesure s'étend en porte à faux par rapport à la cosse de batterie 9. On remarquera que compte tenu de la disposition des différents éléments composant le dispositif de mesure, le bloc de résine 15 à une épaisseur totale inférieure à celle de la cosse de batterie 9.

La figure 3 illustre un second mode de réalisation de l'invention dans lequel le shunt de mesure 16 se présente cette fois sous forme d'une plaque coudée comportant une portion de raccordement 17 ayant une face sur laquelle est fixée l'extrémité 6 de l'âme conductrice du câble 7 tandis que la portion de raccordement 18 opposée à l'extrémité de câble est fixé sur une patte 19 s'étendant parallèlement à l'axe de la cosse de batterie 39. Dans ce mode de réalisation le shunt de mesure 16 comporte des ergots 20 qui s'étendent à partir du bord supérieur du shunt 16 pour délimiter la portion de mesure 21. Dans ce cas la carte électronique non représentée est de préférence montée perpendiculairement au shunt de mesure 16 en introduisant les ergots 20 dans des perçages du circuit électrique porté par la carte électronique.

Les figures 4 à 6 illustrent différentes étapes de la réalisation d'un dispositif de mesure selon un troisième mode de réalisation. Dans ce mode de réalisation le shunt de mesure se présente sous forme d'une plaque 22 plane rectangulaire. Le câble est dénudé sur une longueur légèrement supérieure à la longueur de la plaque 22 pour faire apparaître l'âme conductrice 23 qui est appliquée sur une face de la plaque 22 et soudée de façon autogène à celle-ci par fusion des fils conducteurs formant l'âme conductrice 23. Sur la partie dénudée, l'âme conductrice 23 se présente alors sous forme d'un barreau fixé à la face correspondante de la plaque 22 comme illustré par la figure 5. Comme illustré par la figure 6, l'âme conductrice 23 est ensuite usinée, par exemple par fraisage, pour éliminer la partie centrale de l'âme conductrice 23 de sorte qu'à l'issue de cette opération le shunt de mesure 22 est fixé aux extrémités de deux tronçons de câbles 24 dont les extrémités conductrices 25 sont espacées d'une distance D qui détermine la portion de mesure du shunt de mesure 22.

Comme illustré par la figure 7 une carte électronique 26 comportant sur sa face inférieure des pistes de circuit 27 est fixée sur les extrémités conductrices 25 des tronçons de câbles 24 pour prélever une différence de potentiel entre les extrémités conductrices 25. Comme précédemment la carte électronique 26 est reliée à un câble de transmission de données 28 et l'ensemble est noyé dans un bloc de résine 29.

Bien entendu l'invention n'est pas limitée aux modes de réalisation décrits et on peut y apporter des variantes de réalisation sans sortir du cadre de l'invention tel que défini par les revendications.

En particulier l'invention n'est pas limitée aux formes illustrées du shunt de mesure dont une des portions de raccordement peut être fixée directement sur la paroi latérale ou sur le bord extrême d'une cosse de batterie de structure classique.

## Revendications

1. Dispositif de mesure d'un courant circulant dans un câble (7; 24), le dispositif de mesure comportant un shunt de mesure (1; 16; 22) en forme de plaque monté en série avec le câble et associé à une carte électronique de mesure (11; 26) reliée à une câble de transmission de données' (14; 28), le shunt de mesure comportant une portion de mesure (2; 21) en alliage résistif reliée à des portions de raccordement (4,5 ;17,18) en une seule pièce avec la portion de mesure, de part et d'autre de la portion de mesure (2 ; 21), **caractérisé en ce que** le câble a une extrémité (6 ;25) fixée par une soudure autogène sur une face d'une portion de raccordement du shunt de mesure, et **en ce que** la portion de raccordement (5 ;18) opposée à l'extrémité du câble (6) est directement fixée par une soudure à une patte conductrice d'une cosse de batterie (9 ; 39), ladite cosse comportant une patte conductrice (8 ; 19) réalisée en une seule pièce avec la cosse de batterie.

2. Dispositif de mesure selon la revendication 1 **caractérisé en ce que** la patte conductrice (8) s'étend perpendiculairement à un axe (10) de la cosse de batterie.

3. Dispositif de mesure selon la revendication 2 **caractérisé en ce qu'**il a une épaisseur totale inférieure à la cosse de batterie.

4. Dispositif de mesure selon la revendication 1 **caractérisé en ce que** le shunt de mesure (1) comporte des perçages (3) délimitant la portion de mesure (2) du shunt de mesure, et la carte électronique (11) comporte des tiges de liaison (13) engagées dans les perçages (3).

5. Dispositif de mesure selon la revendication 1 **caractérisé en ce que** des extrémités (25) de tronçons de câbles (24) sont fixées à chacune des portions de raccordement.

## Claims

1. A measuring device for measuring a current flowing in a cable (7; 24), the measuring device comprising a measuring shunt (1; 16; 22) in the form of a plate connected in series with the cable and associated with a measuring electronic card (11; 26) connected to a data transmission cable (14; 28), the measuring shunt comprising a measuring portion (2; 21) of resistive alloy connected to connection portions (4, 5; 17, 18) integral with the measuring portion, on either side of the measuring portion (2; 21), the device being **characterized in that** the cable has one end (6; 25) secured by autogenous welding to one face of a connection portion of the measuring shunt, and **in that** the connection portion (5; 18) remote from the cable end (6) is secured directly by welding to a battery cable terminal (9; 39), the battery cable terminal (9) including a conductive tab (8; 19) integral with the battery cable terminal.

2. A measuring device according to claim 1, **characterized in that** the conductive tab (8) extends perpendicularly to an axis (10) of the battery cable terminal.

3. A measuring device according to claim 2, **characterized in that** it has total thickness less than the thickness of the battery cable terminal.

4. A measuring device according to claim 1, **characterized in that** the measuring shunt (1) includes holes (3) defining the measuring portion (2) of the measuring shunt, and the electronic card (11) includes connection pins (13) engaged in the holes (3).

5. A measuring device according to claim 1, **characterized in that** cable segment ends (25) are secured to each of the connection portions.

## Patentansprüche

1. Messvorrichtung zum Messen eines Stromflusses in einem Kabel (7; 24), wobei die Messvorrichtung einen Mess-Shunt (1; 16; 22) in Form einer Platte umfasst, die in Reihe mit dem Kabel montiert und mit einer elektronischen Messplatine (11; 26) verbunden ist, welche mit einem Datenübertragungskabel (14; 28) verbunden ist, wobei der Mess-Shunt einen Messabschnitt (2; 21) aus einer Widerstandslegierung umfasst, der mit Anschlussabschnitten (4, 5; 17, 18) verbunden ist, die auf beiden Seiten des Messabschnittes (2; 21) einstückig mit diesem ausgebildet sind, **dadurch gekennzeichnet, dass** das Kabel ein Ende (6; 25) hat, das mittels Autogenschweißen auf einer Fläche eines Anschlussabschnittes des Mess-Shunts befestigt ist, und dass der Anschlussabschnitt (5; 18), der dem Ende des Kabels (6) abgewandt ist, direkt mit einer leitenden Zunge eines Batteriekabelschuhs (9; 39) verschweißt ist, wobei der genannte Batteriekabelschuh eine leitende Zunge (8; 19) umfasst, die einstückig mit ihm ausgebildet ist.

2. Messvorrichtung nach Anspruch 1, **dadurch gekennzeichnet, dass** sich die leitende Zunge (8) senkrecht zu einer Achse (10) des Batteriekabelschuhs erstreckt.

3. Messvorrichtung nach Anspruch 2, **dadurch gekennzeichnet, dass** sie eine Gesamtdicke hat, die geringer als die des Batteriekabelschuhs ist.

4. Messvorrichtung nach Anspruch 1, **dadurch gekennzeichnet, dass** der Mess-Shunt (1) Bohrungen (3) umfasst, die den Messabschnitt (2) des Mess-Shunts begrenzen, und die elektronische Platine (11) Verbindungsstifte (13) umfasst, die mit den Bohrungen (3) in Eingriff stehen.

5. Messvorrichtung nach Anspruch 1, **dadurch gekennzeichnet, dass** Enden (25) von Kabelabschnitten (24) an jedem der Anschlussabschnitte befestigt sind.
